# EUROPEAN PATENT APPLICATION

(11) **EP 3 960 350 A1**
(43) Date of publication of application: **02.03.2022**
(21) Application number: 20794110.5
(22) Date of filing: 15.04.2020
(51) Int. Cl.: B23K 1/008, B23K 3/00, B23K 3/08, B23K 31/02, H05K 3/34

(54) **HEATING DEVICE AND METHOD FOR MANUFACTURING SOLDERED OBJECT**

(30) Priority: 26.04.2019 JP 2019086132
(71) Applicant: Origin Company, Limited, Saitama-shi Saitama 338-0823 (JP)
(72) Inventor: TAKEUCHI, Nanami, Saitama-shi Saitama 338-0823 (JP); SHIRAISHI, Arisa, Saitama-shi Saitama 338-0823 (JP); OZAWA, Naoto, Saitama-shi Saitama 338-0823 (JP); SUZUKI, Takayuki, Saitama-shi Saitama 338-0823 (JP)
(74) Representative: Wallin, Nicholas James
(86) International application number: PCT/JP2020/016609
(87) International publication number: WO 2020/218122

(57) **Abstract**

To provide a heating device with which the adhesion of dirt can be prevented with a simple configuration, and a method for manufacturing a soldered object. This heating device 1 is provided with: a chamber 11 in which an object W is accommodated; a stage 13 on which the object W is placed and which demarcates an internal space C inside the chamber 11 into a lower region Ce and an upper region Cf; a heating unit 15 that heats the object W on the stage 13; and gas supply devices 18, 19 that supply gases Ge, F to the lower region Ce. The chamber 11 has formed therein an outlet port 11p in the upper region Cf. The stage 13 forms gaps D that create a flow for allowing the gases Ge, F supplied to the lower region Ce by the gas supply devices 18, 19, to move from the lower region Ce to the upper region Cf along the side walls of the chamber 11. The method for manufacturing includes supplying the object W into the chamber 11, supplying the gas Ge that moves from the lower region Ce to the upper region Cf along the side walls of the chamber 11, and raising the temperature of the object W to perform soldering.

## Description

### TECHNICAL FIELD

The present disclosure relates to heating apparatus and method for manufacturing soldered object, particularly to a heating apparatus and method for manufacturing soldered object, which can prevent adhesion of soil with a simple configuration.

### BACKGROUND ART

For example, when an electronic component is mounted on a substrate, the electronic component is soldered onto the substrate for fixation. In order to perform soldering, the electronic component, the substrate, and the solder are accommodated in a chamber, and then the solder is heated for melting and is thereafter cooled. When the electronic component, the substrate, and the solder are heated for soldering, a vaporized substance is produced from the solder, the substrate, or the like. When soldering is repeated, the vaporized substance as soil possibly adheres to a chamber inner wall. In order to eliminate such inconvenience, gas flow direction adjustment means is provided near a gas inlet port and causes introduced gas to flow along the chamber inner wall, so as to suppress adhesion of the soil (for example, see Patent Document 1).

### Related Art Document

### Patent Document

Patent Document 1: JP-2015-100841 A

### SUMMARY OF THE INVENTION

### PROBLEM TO BE SOLVED BY THE INVENTION

However, in Patent Document 1, the gas flow direction adjustment means has to be provided additionally. Thus, it is preferred to prevent the soil on the inner wall with a simpler configuration.

The present disclosure has been made in view of the above-described problem and therefore has a purpose of providing a heating apparatus and a method for manufacturing a soldered object, which can prevent adhesion of soil with a further simple configuration.

### MEANS FOR SOLVING THE PROBLEM

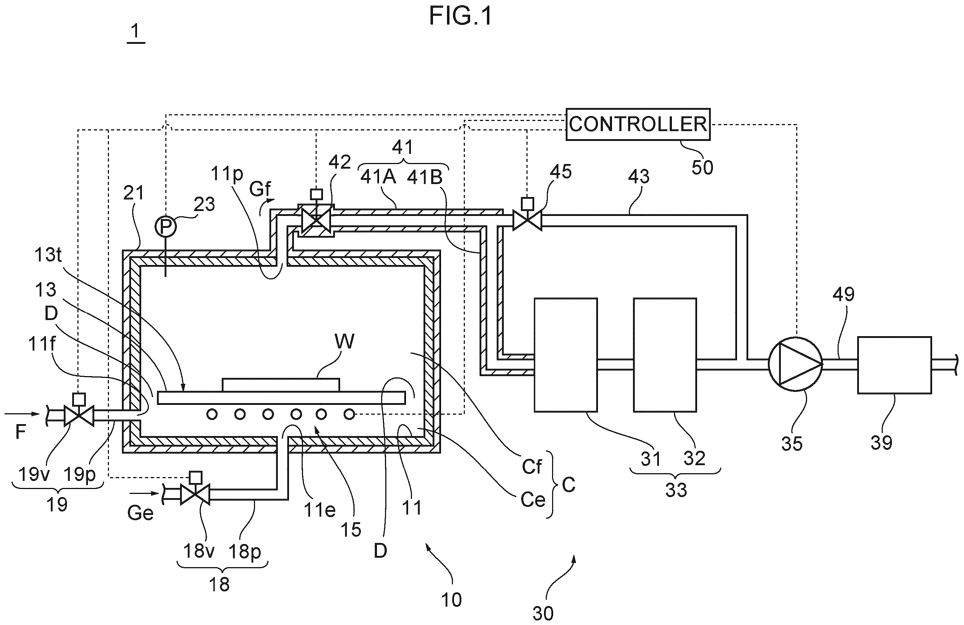

To achieve the above object, a heating apparatus according to the first aspect of the present disclosure includes, as shown in FIG. 1, for example, a chamber 11 configured to accommodate an object W, the object W producing an evaporated substance upon heating; a stage 13 on which the object W accommodated in the chamber 11 is placed, the stage 13 partitioning an internal space C of the chamber 11 into a lower region Ce at a lower portion and an upper region Cf at an upper portion; a heating section 15 configured to heat the object W placed on the stage 13; and a gas supplier 18 and 19 configured to supply gas Ge and F to the lower region Ce, wherein the chamber 11 has an outlet port 11p for discharging fluid from the chamber 11, the outlet port 11p being formed in the upper region Cf, and wherein the stage 13 includes a gap D through which the gas Ge and F supplied to the lower region Ce by the gas supplier 18 and 19 flows from the lower region Ce to the upper region Cf along a wall surface of the chamber 11.

With such a configuration, it is possible to generate the flow of the gas along the wall surface of the chamber by the stage and to suppress adhesion of the substance to the wall surface of the chamber without providing a special component.

As for a heating apparatus according to the second aspect of the present disclosure, as shown in FIG. 1, for example, the heating apparatus 1 according to the first aspect, further includes a chamber wall surface temperature decrease suppression member 21 configured to suppress a temperature decrease of the wall surface of the chamber 11.

With such a configuration, it is possible to suppress the adhesion of condensed substance to the wall surface of the chamber caused by solidification of the substance that is associated with the temperature decrease of the wall surface of the chamber.

As for a heating apparatus according to the third aspect of the present disclosure, as shown in FIG. 1, for example, the heating apparatus 1 according to the first or second aspect, further includes a substance catching section 33 configured to catch the substance, which is contained in the fluid Gf that has flowed out from the chamber 11 via the outlet port 11p.

With such a configuration, it is possible to suppress outflow of the substance to the downstream side of the substance catching section and to suppress the number of maintenance of equipment arranged on the downstream side and the amount of discharge of the substance.

As for a heating apparatus according to the fourth aspect of the present disclosure, as shown in FIG. 1, for example, the heating apparatus 1 according to the third aspect, further includes a discharge channel 41 for introducing, to the substance catching section 33, the fluid Gf that has flowed out via the outlet port 11p; a vacuum pump 35 configured to suction the fluid from the chamber 11, the vacuum pump 35 being disposed downstream of the substance catching section 33; a bypass channel 43 configured to enable the fluid Gf that has flowed out from the chamber 11 to bypass the substance catching section 33 and be delivered to the vacuum pump 35; an on-off valve 45 configured to open and close the bypass channel 43; a substance flow rate detection section 23 configured to directly or indirectly detect a flow rate of the substance in the fluid Gf that has flowed out from the chamber 11; and a controller 50 configured to close the on-off valve 45 when a value detected by the substance flow rate detection section 23 exceeds a predetermined value, and to open the on-off valve 45when the value detected by the substance flow rate detection section 23 is equal to or lower than the predetermined value.

With such a configuration, it is possible to suppress degradation of performance of the vacuum pump and to reduce a time that is required to reduce a pressure in the chamber to be lower than the predetermined pressure.

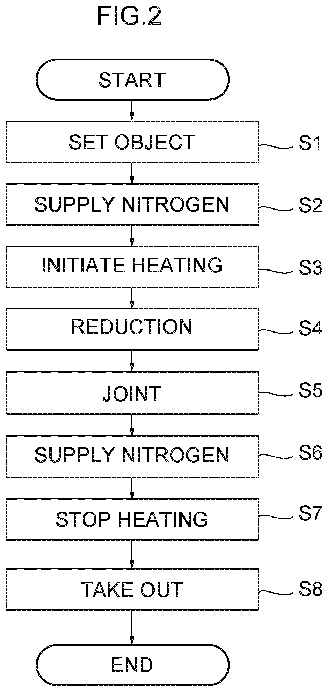

As for a method for manufacturing a soldered object according to the fifth aspect of the present disclosure, as shown in FIGs. 1 and 2, for example, the method is a method for manufacturing a soldered object W by using the heating apparatus 1 according to any one of the first to fourth aspects, and the method includes providing the object W, which has a solder, in the chamber 11 (S1); supplying the gas Ge and F to the chamber 11 such that the gas supplied to the lower region Ce flows from the lower region Ce to the upper region Cf along a wall surface of the chamber 11 (S2, S4, S6); and effecting a solder joint by increasing a temperature of the object W (S5).

With such a configuration, it is possible to manufacture the soldered object while suppressing the adhesion of the substance to the wall surface of the chamber.

### ADVANTAGE OF THE INVENTION

According to the present disclosure, it is possible to generate the flow of the gas along the wall surface of the chamber by the stage and to suppress adhesion of the substance to the wall surface of the chamber without providing a special component.

### BRIEF DESCRIPTION OF DRAWINGS

FIG. 1 is a schematic configuration view of a heating apparatus according to an embodiment of the present disclosure.
FIG. 2 is a flowchart illustrating an operation procedure of the heating apparatus according to the embodiment of the present disclosure.
FIG. 3 is a conceptual view illustrating a flow of a fluid in a chamber after being heated.

### DESCRIPTION OF EMBODIMENTS

This application is based on the Patent Application No. 2019-086132 filed on April 26, 2019 in Japan, the contents of which are hereby incorporated in its entirety by reference into the present application, as part thereof.

The present disclosure will become more fully understood from the detailed description given hereinbelow. Further range of application of the present disclosure will become clearer from the detailed description given hereinbelow. However, the detailed description and the specific embodiment are illustrated of desired embodiments of the present disclosure and are described only for the purpose of explanation. Various changes and modifications will be apparent to those ordinary skilled in the art on the basis of the detailed description.

The applicant has no intention to give to public any disclosed embodiment. Among the disclosed changes and modifications, those which may not literally fall within the scope of the patent claims constitute, therefore, a part of the present invention in the sense of doctrine of equivalents.

Description will hereinafter be made of an embodiment of the present disclosure with reference to the drawings. The same or corresponding members are denoted with the same reference numerals in all the drawings, and their descriptions are not repeated.

First, with reference to FIG. 1, a description will be made on a heating apparatus 1 according to an embodiment of the present disclosure. FIG. 1 is a schematic configuration view of the heating apparatus 1. The heating apparatus 1 is an apparatus that heats an object W. In this embodiment, a description will be made on the assumption that the object W is formed by mounting an electronic component such as a semiconductor chip on a substrate by using solder. The object W, in a state where the solder is not melted, is placed in the heating apparatus 1. Then, when the solder is heated by the heating apparatus 1, is melted, and is thereafter cooled, the electronic component is soldered onto the substrate. Just as described, in this embodiment, the heating apparatus 1 functions as a soldering apparatus. The heating apparatus 1 has: a heat treatment section 10 that is a component around a heating portion for melting of the solder; an exhaust treatment section 30 that is a component around a portion in which exhaust gas produced in a soldering process is cleaned; and a controller 50. The heat treatment section 10 includes: a chamber 11 that accommodates the object W to be heated; a stage 13 on which the object W is placed; a heater 15 for heating the object W; a nitrogen supply section 18 that supplies nitrogen gas Ge into the chamber 11; and a formic acid supply section 19 that supplies formic acid gas F into the chamber 11.

The chamber 11 forms an internal space C in which soldering processing of the object W (one aspect of heat treatment) is executed. Soldering is preferably performed under vacuum (at a lower pressure than the atmospheric pressure). Accordingly, the chamber 11 is configured to have a structure capable of resisting at least a degree of vacuum that is appropriate for soldering, preferably, a lower degree of vacuum (for example, about 50 Pa (an absolute pressure)) than the above. From a perspective of facilitating manufacturing, the chamber 11 is typically formed in a rectangular parallelepiped shape. However, from a perspective of pressure resistance, the chamber 11 may be formed such that an outer circumferential wall thereof is a curved surface. The chamber 11 is formed with inlet/outlet ports for various fluids that are used in a series of soldering steps. More specifically, the chamber 11 is formed with: a nitrogen inlet port 11e through which the nitrogen Ge as inert gas is introduced; a formic acid inlet port 11f through which the formic acid F is introduced; and an outlet port 11p of which the fluids in the chamber 11 flows out. In this embodiment, the nitrogen inlet port 11e is formed in a bottom surface of the chamber 11, the formic acid inlet port 11f is formed in a lower portion of the chamber 11, and the outlet port 11p is formed in a ceiling surface of the chamber 11. In addition, the chamber 11 is provided with a shutter (not illustrated) that opens/closes an opening (not illustrated) through which the object W can be placed in/taken out of the chamber 11.

The stage 13 is, in this embodiment, formed in a plate shape and arranged in the chamber 11. From a perspective of placement stability, a placement surface 13t, on which the object W is placed, in the stage 13 is formed to be flat. Typically, a reverse surface of the placement surface 13t is also formed to be flat. In the chamber 11, the stage 13 is typically installed such that the placement surface 13t is in a horizontal position. However, the stage 13 may be tilted with respect to a horizontal direction (an expansion direction of the placement surface 13t may have a horizontal component and a vertical component) in such a degree that the placed object W can remain to be placed (such a degree that the placed object does not slip down). The stage 13 is formed from a material capable of transferring heat generated by the heater 15 to the object W, and is typically formed from graphite. However, the stage 13 may be formed from metal with high thermal conductivity. When the stage 13 is formed from graphite, the stage 13 has such an advantage of corrosion resistance against formic acid and such an advantage that a temperature increase thereof is rapid due to small heat capacity. Here, a heat amount that is transferred from the heater 15 to the object W via the stage 13 is a heat amount capable of increasing a temperature of the object W to a required temperature for soldering, and the stage 13 is typically configured that a temperature thereof can be increased to be equal to or higher than the required temperature for soldering of the object W. The stage 13 is formed such that an area thereof possible to contact the object W is larger than an area of the surface of the object W and that a contour thereof (a contour of an outer circumferential edge thereof) is one size smaller than an inner wall circumference of the chamber 11 in a horizontal cross section. In this way, the stage 13 is formed in such size that a gap D between the stage 13 and a wall surface of the chamber 11 has a predetermined distance. Here, the predetermined distance is a distance that is suited for the fluid flowing through the gap D to form a flow along the wall surface of the chamber 11. The stage 13 only needs to be formed such that at least a portion thereof contacting the object W is formed from a material, a temperature of which can be increased to be equal to or higher than the soldering temperature. An outer circumference of the portion contacting the object W in the stage 13 may be formed of a different material from the material used to form the portion contacting the object W. In other words, the entire surface of the stage 13 may not serve as a heating target portion, and the stage 13 may be configured to be expanded by attaching an accessory such as a baffle plate to the heating target portion (a configuration including the stage).

Hereinafter, for convenience of the description, in the case where the internal space C of the chamber 11 is divided by an imaginary plane that is extended in the same plane as the plate-shaped stage 13, a space below the imaginary plane in the chamber 11 will be referred to as a lower region Ce, and a space above the imaginary plane in the chamber 11 will be referred to as an upper region Cf. The above-described nitrogen inlet port 11e and formic acid inlet port 11f are formed in the lower region Ce while the outlet port 11p is formed in the upper region Cf.

The heater 15 is, in this embodiment, arranged at a position near the stage 13 in the lower region Ce. In this embodiment, the heater 15 is configured by aligning plural infrared lamps (hereinafter referred to as "IR lamps") along the back surface of the stage 13 at appropriate intervals. The heater 15 heats the object W that is placed on the stage 13 via the stage 13, and corresponds to the heating section. Here, a cooling section (not illustrated) in a comb tooth shape may be provided between two each of the plural IR lamps that constitute the heater 15, and the cooling section contacts the back surface of the stage 13 and thereby cools the stage 13 (and thus the object W). This cooling section is preferably configured to be able to reciprocate in a manner to approach (during cooling) and separate from (during non-cooling) the stage 13.

The nitrogen supply section 18 is a device that supplies the nitrogen gas Ge as gas to the lower region Ce, and corresponds to the gas supplier. The nitrogen supply section 18 has: a nitrogen source (not illustrated); a pipe 18p which guides the nitrogen gas Ge from the nitrogen source (not illustrated) into the chamber 11; and a control valve 18v that is disposed in the pipe 18p. The pipe 18p is connected to the nitrogen inlet port 11e. The nitrogen supply section 18 is configured to supply, at a source pressure, the nitrogen gas Ge that is in the nitrogen source (not illustrated) into the chamber 11 at the time when the control valve 18v is opened, and is configured to interrupt the supply of the nitrogen gas Ge into the chamber 11 at the time when the control valve 18v is closed. The formic acid supply section 19 has: a formic acid source (not illustrated); a pipe 19p which guides the formic acid F from the formic acid source (not illustrated) into the chamber 11; and a control valve 19v that is disposed in the pipe 19p. The formic acid source (not illustrated) has an evaporation section that evaporates the formic acid F, and is configured to be able to supply evaporated formic acid F into the chamber 11. The pipe 19p is connected to the formic acid inlet port 11f. The formic acid supply section 19 is configured to supply the evaporated formic acid F into the chamber 11 at the time when the control valve 19v is opened, and is configured to interrupt the supply of formic acid F into the chamber 11 at the time when the control valve 19v is closed. In this embodiment, since the formic acid supply section 19 supplies the evaporated formic acid F to the lower region Ce, the formic acid supply section 19 also corresponds to the gas supplier.

In the heat treatment section 10, a thermal insulator 21 is attached to an entire outer surface of the chamber 11. Due to presence thereof, this thermal insulator 21 can suppress a temperature decrease of the wall surface of the chamber 11, and thus corresponds to the chamber wall surface temperature decrease suppression member. In addition, the heat treatment section 10 is provided with a pressure gauge 23 as a pressure detection section that detects an internal pressure of the chamber 11.

Next, a description will be made on a configuration of the exhaust treatment section 30. The exhaust treatment section 30 has: a substance catching section 33 that catches a substance, which is contained in a fluid Gf that has flowed out from the chamber 11; and a vacuum pump 35 that suctions the fluid from the chamber 11. The substance catching section 33 is provided on a downstream side of the chamber 11. In this embodiment, the substance catching section 33 includes: a water-cooling trap 31; and a mist filter 32 that is provided on a downstream side of this water-cooling trap 31.

The water-cooling trap 31 catches the substance that is produced and evaporated from the object W (hereinafter referred to as an "evaporated substance") when the object W is heated in the chamber 11. The water-cooling trap 31 is configured to cool the fluid Gf, which flows thereinto from the inside of the chamber 11, and to concentrate the evaporated substance contained in the fluid Gf into a liquid or a solid. The mist filter 32 catches the evaporated substance, which is included in a mist in the case where the fluid discharged from the water-cooling trap 31 contains the evaporated substance in the mist form.

The substance catching section 33 is disposed in a discharge pipe 41. One end of the discharge pipe 41 is connected to the outlet port 11p. The discharge pipe 41 functions as a channel through which the fluid Gf that has flowed out from the inside of the chamber 11 flows into the substance catching section 33 via the outlet port 11p, and corresponds to the discharge channel. A bypass pipe 43 is connected to the discharge pipe 41, and the bypass pipe 43 is provided in parallel with the substance catching section 33 in a manner to connect an upstream portion and a downstream portion of the substance catching section 33. The bypass pipe 43 functions as a channel that delivers the fluid on an upstream side of the substance catching section 33 to a downstream side of the substance catching section 33 by bypassing the substance catching section 33, and corresponds to the bypass channel. In the bypass pipe 43, an on-off valve 45 that opens and closes the channel is disposed. The on-off valve 45 is configured that, when being opened, the on-off valve 45 can cause the fluid to flow into the bypass pipe 43 and, when being closed, the on-off valve 45 can interrupt the flow of the fluid in the bypass pipe 43.

A downstream end of the discharge pipe 41 and a downstream end of the bypass pipe 43 are connected to one end of a merging discharge pipe 49. The merging discharge pipe 49 is a pipe that functions as a channel in which the fluid that has flowed through the discharge pipe 41 and the fluid that has flowed through the bypass pipe 43 are merged and flow to the downstream side. In regard to the discharge pipe 41, for convenience, a portion from the outlet port 11p to a portion to which an upstream end of the bypass pipe 43 is connected will be referred to as a common discharge pipe 41A, and a portion from the portion to which the upstream end of the bypass pipe 43 is connected to a connected portion with the merging discharge pipe 49 will be referred to as a catching discharge pipe 41B. In the common discharge pipe 41A, an outlet valve 42 capable of closing the channel is disposed. Due to provision of the outlet valve 42, it is possible to form a sealed space in the chamber 11 in cooperation with the control valve 18v and the control valve 19v. A thermal insulator is attached to the entire outer surface of the discharge pipe 41 from the outlet port 11p to an inlet port of the water-cooling trap 31. The thermal insulator that is attached to the discharge pipe 41 is typically of the same type as the thermal insulator 21 attached to the outer surface of the chamber 11, but may be of a different type from the thermal insulator 21.

The vacuum pump 35 is disposed in the merging discharge pipe 49 and is configured to be able to suction the fluid Gf from the chamber 11 via the discharge pipe 41 and to suction the fluid Gf from the chamber 11 also via the bypass pipe 43 when the on-off valve 45 is opened. Since the vacuum pump 35 is provided on the downstream side of the substance catching section 33, it is possible to suppress a flow of the evaporated substance thereinto by closing the on-off valve 45. In this way, life-span of the vacuum pump 35 can be extended. In this embodiment, a catalyst 39 is provided in a portion on a downstream side of the vacuum pump 35 in the merging discharge pipe 49. The catalyst 39 reduces concentration of formic acid F, which has been used for soldering in the chamber 11, to such concentration that does not harm the environment. The catalyst 39 is configured to receive oxygen in addition to the gas containing formic acid F and to break down formic acid F into carbon dioxide and water. A catalyst that promotes such breakdown reaction of formic acid F is used as the catalyst 39. The catalyst 39 is configured that the concentration of formic acid F in the flowing fluid becomes equal to or lower than about 5 ppm, is preferably configured that the concentration of formic acid F in the flowing fluid becomes lower than 0.2 ppm, and is further preferably configured that the concentration of formic acid F in the flowing fluid becomes 0 ppm when by optimizing a condition.

The controller 50 is equipment that controls operation of the heating apparatus 1. The controller 50 is connected to the heater 15 either wirelessly or in a wired fashion and is configured to be able to heat the stage 13 by changing on/off and output of the heater 15. In addition, the controller 50 is connected to each of the nitrogen supply section 18 and the formic acid supply section 19 either wirelessly or in the wired fashion, and is configured to be able to supply the nitrogen gas Ge toward the chamber 11 through opening/closing operation of the control valve 18v and supply formic acid F toward the chamber 11 through opening/closing operation of the control valve 19v. Furthermore, the controller 50 is connected to the vacuum pump 35 either wirelessly or in the wired fashion and is configured to be able to execute control for stopping the vacuum pump 35, which is constantly actuated during a stationary time, in case of emergency. Moreover, the controller 50 is connected to the outlet valve 42 either wirelessly or in the wired fashion and is configured to be able to execute opening/closing control of the outlet valve 42. The controller 50 is connected to the on-off valve 45 either wirelessly or in the wired fashion and is configured to be able to control of opening/closing of the on-off valve 45. In this embodiment, since the on-off valve 45 is opened/closed according to the internal pressure of the chamber 11, the pressure gauge 23, which detects the internal pressure of the chamber 11, is provided to the chamber 11. The controller 50 is connected to the pressure gauge 23 either wirelessly or in the wired fashion, and is configured to be able to receive, as a signal, a value detected by the pressure gauge 23. In addition, the controller 50 is connected to a thermometer (not illustrated) that detects a temperature of the placement surface 13t of the stage 13 either wirelessly or in the wired fashion, and is configured to be able to receive, as a signal, a value detected by the thermometer (not illustrated).

Next, with reference to FIG. 2, a description will be made on a manufacturing method for a soldered object by using the heating apparatus 1. FIG. 2 is a flowchart illustrating an operation procedure of the heating apparatus 1. In the following description on the manufacturing method for the soldered object, FIG. 1 is appropriately referred when the configuration of the heating apparatus 1 is described. The following description on the manufacturing method for the soldered object by using the heating apparatus 1 also serves as a description on operation of the heating apparatus 1. During actuation of the heating apparatus 1, which will be described below, the vacuum pump 35 is constantly actuated. Furthermore, typically, as an initial state, the control valve 18v, the control valve 19v, and the outlet valve 42 are closed, and the on-off valve 45 is closed when the value detected by the pressure gauge 23 exceeds a predetermined value, which will be described below, and is opened when the value detected by the pressure gauge 23 is equal to or lower than the predetermined value. In this embodiment, in order to solder the object W in a state where the electronic component and the solder are provided on the substrate, first, the object W is inserted in the chamber 11 and placed on the placement surface 13t of the stage 13 (a provision step: S1). At this time, the object W is placed at a position at which the temperature of the stage 13 can easily be changed (the heating target portion). Once the object W is placed on the stage 13 in the chamber 11, the controller 50 controls the outlet valve 42 to open to make the internal pressure of the chamber 11 negative (a lower pressure than a pressure on the outside of the chamber 11 (hereinafter referred to as a "surrounding pressure")). Then, when the internal pressure of the chamber 11 is lowered to a predetermined pressure, the controller 50 controls the outlet valve 42 to close to seal the chamber 11.

Next, the controller 50 controls the control valve 18v to open to supply the nitrogen gas Ge into the chamber 11 (S2). Then, the nitrogen gas Ge is spread over the inside of the chamber 11, and the internal pressure of the chamber 11 substantially corresponds to the surrounding pressure. When the internal pressure of the chamber 11 becomes the surrounding pressure, the controller 50 controls the outlet valve 42 to open. Then, the nitrogen gas Ge that is supplied to the chamber 11 moves from the lower region Ce to the upper region Cf and flows through the chamber 11 in a manner to flow out to the discharge pipe 41 via the outlet port 11p. Next, the controller 50 controls the heater 15 to turn on, and then heating the stage 13 and the object W is initiated (S3). At this time point, the supply of the nitrogen gas Ge into the chamber 11 still continues. Here, the initiation of heating (S3) may be executed before the supply of the nitrogen gas Ge (S2). When an appropriate time has passed since the temperature of the stage 13 or the object W reached a reduction temperature, the controller 50 controls the control valve 18v to close to stop the supply of the nitrogen gas Ge into the chamber 11. In this way, the supply of the nitrogen gas Ge (S2) is terminated. When the control valve 18v is closed, the internal pressure of the chamber 11 becomes the negative pressure. When the internal pressure of the chamber 11 is lowered to the predetermined pressure, the controller 50 controls the outlet valve 42 to close to seal the chamber 11. Here, the reduction temperature is a temperature that is lower than a melting point of the solder in the object W, and is an appropriate temperature for reduction processing of an oxidized film on the object W using formic acid F.

Next, the controller 50 controls the control valve 19v to open to supply formic acid F into the chamber 11. In this way, the reduction processing for reducing the oxidized film, which is formed on a surface of the solder in the object W, a surface of the substrate, or the like, is executed by using formic acid F (S4). When the control valve 19v is opened, formic acid F is spread over the inside of the chamber 11, and the internal pressure of the chamber 11 substantially corresponds to the surrounding pressure. When the internal pressure of the chamber 11 becomes the surrounding pressure, the controller 50 controls the outlet valve 42 to open. Then, formic acid F that is supplied to the chamber 11 moves from the lower region Ce to the upper region Cf and flows through the chamber 11 in a manner to flow out to the discharge pipe 41 via the outlet port 11p. When the reduction processing by using formic acid F is completed, the controller 50 controls the control valve 19v to open to stop the supply of formic acid F into the chamber 11. When the control valve 19v is closed, the internal pressure of the chamber 11 becomes the negative pressure. When the internal pressure of the chamber 11 is lowered to the predetermined pressure, the controller 50 controls the outlet valve 42 to close to seal the chamber 11.

Next, the controller 50 controls the heater 15 to increase power of the heater 15 to increase each of the temperatures of the stage 13 and the object W to a joint temperature, which exceeds the melting point of the solder in the object W, which melts the solder, and then solder joint is executed (a joint step: S5). This joint step (S5) is executed in a vacuum state of the chamber 11. When the solder joint is terminated, the controller 50 controls the control valve 18v to open to supply the nitrogen gas Ge into the chamber 11 (S6). Then, the nitrogen gas Ge is spread over the inside of the chamber 11, and the internal pressure of the chamber 11 substantially corresponds to the surrounding pressure. When the internal pressure of the chamber 11 becomes the surrounding pressure, the controller 50 controls the outlet valve 42 to open. Then, the nitrogen gas Ge moves from the lower region Ce to the upper region Cf and flows through the chamber 11 in the manner to flow out to the discharge pipe 41 via the outlet port 11p. Next, the controller 50 controls the heater 15 to turn off to stop heating the stage 13 and the object W (S7). The heater 15 is turned off while the nitrogen gas Ge flows through the chamber 11. Consequently, the inside of the chamber 11 is cooled, and the temperature of the inside of the chamber 11 is decreased. When the temperature of the inside of the chamber 11 is decreased to a substantially normal temperature (ambient temperature), the controller 50 controls the control valve 18v to close to stop the supply of the nitrogen gas Ge into the chamber 11. In this way, the supply of the nitrogen gas Ge (S6) is terminated. In addition, the controller 50 controls the outlet valve 42 to close, and the object W is taken out of the chamber 11 (S8). From what have been described so far, one cycle of the heat treatment (soldering) of the object W is terminated. In the case where the next object W is treated, the above-described flow is repeated.

In the above-described flow, in the reduction step (S4) and the joint step (S5), the evaporated substance is produced by heating the object W. In the case where a large amount of the evaporated substance remains in the chamber 11 after the joint step (S5), and the temperature of the inside of the chamber 11 is decreased by stopping heating (S7), the evaporated substance is condensed, adheres to the inner wall of the chamber 11, and thereby soils the inner wall of the chamber 11. In the case where the inner wall of the chamber 11 is soiled and the reduction step (S4) and the joint step (S5) are executed for another object W thereafter, soil that adheres to the inner wall of the chamber 11 possibly adheres to the other object W and may cast negative impact on the other object W. In view of the above, in this embodiment, in order to suppress adhesion of the soil on the wall surface of the chamber 11, the nitrogen gas Ge is supplied before and after the series of steps including the reduction step (S4) and the joint step (S5) (gas supply steps: S2, S6), and the inside of the chamber 11 is thereby cleaned. In addition, the supply of formic acid F (corresponding to the gas supply step) in the reduction step (S4) also contributes to cleaning of the inside of the chamber 11.

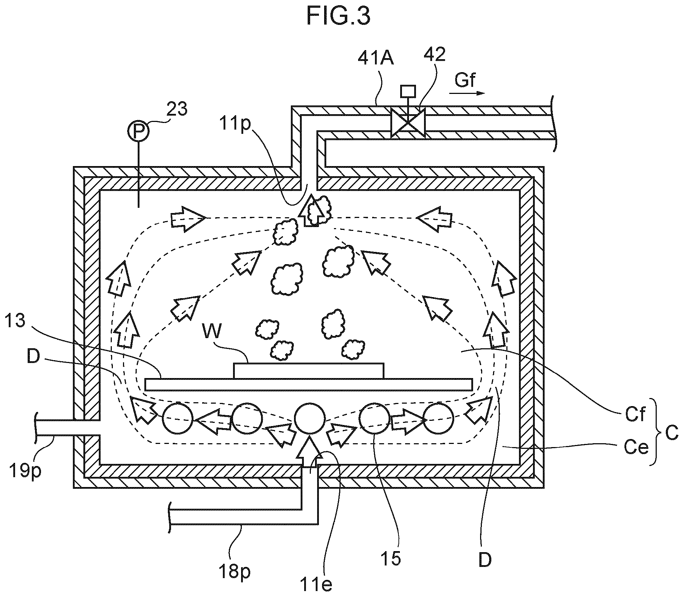

As illustrated in FIG. 3, in the chamber 11, each of the nitrogen gas Ge and formic acid F, which is supplied into the chamber 11, flows from the lower region Ce to the upper region Cf since the nitrogen inlet port 11e and the formic acid inlet port 11f are provided in the lower region Ce, and the outlet port 11p is provided in the upper region Cf. At this time, since the stage 13 is provided in the chamber 11, the nitrogen gas Ge, which flows into the chamber 11 via the nitrogen inlet port 11e, or formic acid F, which flows into the chamber 11 via the formic acid inlet port 11f, circumvents the stage 13 and moves to the upper region Cf through the gap D between the stage 13 and the inner wall of the chamber 11. Since the gap D has the predetermined distance, the nitrogen gas Ge or formic acid F, which has flowed through the gap D, flows along the inner wall of the chamber 11 in the upper region Cf and then flows toward the outlet port 11p. Since the nitrogen gas Ge or formic acid F flows along the inner wall of the chamber 11, it is possible to suppress the evaporated substance from remaining at a position near the wall surface of the chamber 11. Thus, it is possible to suppress the evaporated substance from being condensed and adhering to the wall surface of the chamber 11. Conventionally, it is general to arrange the catalyst, the filter, and the like in the lower portion of the chamber. Thus, it is general to provide the discharge port in a bottom portion of the chamber. For this reason, in order to produce a gas flow along the wall surface of the chamber, it is necessary to provide the gas flow direction adjustment means in an upper portion of the chamber. Meanwhile, in the heating apparatus 1 according to this embodiment, the configuration of the stage 13 is devised, and thus it is possible to produce the gas flow along the wall surface of the chamber 11 by the gap D between the stage 13 and the wall surface of the chamber 11 without providing a special component such as the conventional gas flow direction adjustment means. In addition, in the heating apparatus 1, since the thermal insulator 21 is attached to the chamber 11, the temperature decrease of the wall surface of the chamber 11 is suppressed, which suppresses the condensation of the evaporated substance. Therefore, it is possible to prevent the wall surface of the chamber 11 from being made dirty.

During the actuation of the above-described heating apparatus 1, the fluid Gf that has flowed out from the chamber 11 via the outlet port 11p (hereinafter also referred to as "discharged gas Gf") first flows through the common discharge pipe 41A. When the value detected by the pressure gauge 23 exceeds the predetermined value, the on-off valve 45 is closed. Thus, the discharged gas Gf, which has flowed through the common discharge pipe 41A, does not flow into the bypass pipe 43 but flows through the catching discharge pipe 41B, and then flows into the substance catching section 33. Here, since the thermal insulator 21 is attached to the discharge pipe 41 from the outlet port 11p to the substance catching section 33, the condensation of the evaporated substance contained in the discharged gas Gf is suppressed by suppressing a temperature decrease of the discharged gas Gf. In this way, it is possible to suppress adhesion of the soil to an inner surface of the discharge pipe 41. The discharged gas Gf that has flowed into the substance catching section 33 is first cooled in the water-cooling trap 31. Then, the evaporated substance contained in the discharged gas Gf is converted into the liquid or the solid, and is removed from the discharged gas Gf. Next, the discharged gas Gf flows into the mist filter 32. In the case where the discharged gas Gf discharged from the water-cooling trap 31 contains the evaporated substance in the mist form, the mist filter 32 catches and removes the evaporated substance in the mist form from the discharged gas Gf. The discharged gas Gf, from which the evaporated substance is removed just as described, flows through the vacuum pump 35, then flows through the merging discharge pipe 49, and is discharged to the outside of the system. As described above, since the evaporated substance possibly contained in the discharged gas Gf is removed by the substance catching section 33, it is possible to suppress the evaporated substance from flowing to the downstream side of the substance catching section 33. As a result, it is possible to maintain the equipment, such as the vacuum pump 35, that is arranged on the downstream side of the substance catching section 33, and it is also possible to suppress the evaporated substance from flowing to the outside of the system.

In the case where the discharged gas Gf, which has flowed out of the chamber 11, flows through the substance catching section 33, due to resistance of the substance catching section 33, it takes a longer time for the internal pressure of the chamber 11 to reach a degree of vacuum as an indication of the termination of discharging of the discharged gas Gf (for example, approximately 50 Pa (the absolute pressure), hereinafter referred to as a "stop pressure") than that in a case where the discharged gas Gf does not flow through the substance catching section 33. For this reason, in this embodiment, when the value received from the pressure gauge 23 becomes equal to or lower than the predetermined value, the controller 50 controls the on-off valve 45 to open. When the on-off valve 45 is opened, the discharged gas Gf, which has flowed through the common discharge pipe 41A, flows into the bypass pipe 43 with lower resistance than the catching discharge pipe 41B, bypasses the substance catching section 33, and flows through the vacuum pump 35. In this way, it is possible to reduce the time that is required for the internal pressure of the chamber 11 to reach the stop pressure. The predetermined value is a value with which it can be estimated that the pressure is lowered to such an extent that the evaporated substance remaining in the chamber 11 does not adversely affect the components, such as the vacuum pump 35, that is present on the downstream side of the substance catching section 33, and can be set to a value that corresponds to a pressure of 1/100 of the surrounding pressure (typically, the atmospheric pressure), for example. When the internal pressure of the chamber 11 becomes the pressure of 1/100 of the surrounding pressure, it can be considered that 99% of the fluid in the chamber 11 is discharged, and the evaporated substance remaining in the chamber 11 can be regarded as not to cast the negative impact on the configuration on the downstream side of the substance catching section 33. The internal pressure of the chamber 11 is lowered to such a value typically when the vacuum pump 35 keeps being operated in a state where the fluid does not flow into the chamber 11. When this is applied to the above-described flow, this corresponds to a period before the supply of the nitrogen gas Ge (S2), a period from the stop of the supply of the nitrogen gas Ge (S2) to a time before the supply of formic acid F (S4), and a period from the stop of the supply of formic acid F (S4) to a time before the supply of the nitrogen gas Ge (S6). Here, an amount of the evaporated substance in the chamber 11 is reduced as the gas in the chamber 11 is discharged and an amount of the remaining gas in the chamber 11 is reduced. Thus, a flow rate of the evaporated substance that flows out of the chamber 11 is also reduced. In addition, the value detected by the pressure gauge 23 also varies according to the amount of the remaining gas in the chamber 11. Therefore, the pressure gauge 23 can indirectly detect the flow rate of the evaporated substance and corresponds to the substance flow rate detection section.

As it has been described so far, in the heating apparatus 1 according to this embodiment, the nitrogen gas Ge and formic acid F that are supplied to the lower region Ce flow through the gap D between the stage 13 and the wall surface of the chamber 11 and move to the upper region Cf along the wall surface of the chamber 11. Therefore, it is possible to suppress the evaporated substance from being condensed at the position near the wall surface of the chamber 11 and adhering to the wall surface of the chamber 11 without adding the special component. In addition, since the thermal insulator 21 is attached to the chamber 11, the temperature decrease of the wall surface of the chamber 11 can be suppressed, which can suppress the condensation of the evaporated substance. Furthermore, since the discharged gas Gf, which has flowed out of the chamber 11, flows through the substance catching section 33, it is possible to suppress the evaporated substance from flowing to the downstream side of the substance catching section 33. Moreover, in the case where the discharged gas Gf is discharged, when the value detected by the pressure gauge 23, which detects the internal pressure of the chamber 11, is equal to or lower than the predetermined value, the on-off valve 45 is opened to flow the discharged gas Gf through the bypass pipe 43. Thus, it is possible to reduce the time that is required to lower the internal pressure of the chamber 11 to the stop pressure.

In the description that has been made so far, the inert gas is the nitrogen gas. However, the inert gas that is other than the nitrogen gas, such as argon gas, can be used. However, from a perspective of ease of obtainment, the nitrogen gas is preferably used as the inert gas.

In the description that has been made so far, the heater 15 is disposed in the chamber 11. However, the heater 15 may be arranged on the outside of the chamber 11 (a position below the bottom surface of the chamber 11), and a portion of the chamber 11 between the heater 15 and the stage 13 may be made transparent. Then, the stage 13 may be heated by radiation heat from the heater 15.

In the description that has been made so far, the chamber wall surface temperature decrease suppression member is the thermal insulator. However, by using a heater such as a rubber heater, not only heat dissipation from the chamber 11 may be suppressed, but also the temperature decrease of the wall surface of the chamber 11 may be suppressed by actively applying the heat to the chamber 11.

In the description that has been made so far, the substance catching section 33 includes the water-cooling trap 31 and the mist filter 32. However, in the case where either the water-cooling trap 31 or the mist filter 32 is sufficient, the other thereof may be omitted. Meanwhile, in the case where the water-cooling trap 31 and the mist filter 32 are insufficient, a device capable of catching the evaporated substance may be provided additionally. Alternatively, in the case where the discharge of the discharged gas Gf containing the evaporated substance to the outside of the system is not problematic, the substance catching section 33 may not be provided (may be omitted).

In the description that has been made so far, the substance flow rate detection section is the pressure gauge 23. However, the substance flow rate detection section may be a flowmeter that measures an actual flow rate, a differential pressure gauge, or the like.

In the description that has been made so far, formic acid is used for the reduction processing of the oxidized film on the object W. However, the reduction processing of the oxidized film on the object W may be executed by using reducing gas that is other than formic acid and that is gas with a reductive property, such as carboxylic acid or hydrogen.

In the description that has been made so far, the contour of the stage 13 (the contour of the outer circumferential edge) is formed to be one size smaller than the inner wall circumference of the chamber 11, and the gap D is thereby formed between the contour of the stage 13 and the inner wall of the chamber 11. However, it may be configured that a through hole is formed in the outer circumference of the stage 13 while the contour of the stage 13 contacts the inner wall of the chamber 11 and that this through hole serves as the gap D.

In the description that has been made so far, the nitrogen gas Ge and formic acid F are supplied to the lower region Ce, each of the nitrogen supply section 18 and the formic acid supply section 19 functions as the gas supplier, and the nitrogen gas Ge and formic acid F flow along the inner wall of the chamber 11. In this way, the evaporated substance is suppressed from being condensed at the position near the wall surface of the chamber 11 and from adhering to the wall surface of the chamber 11. However, it may be configured that formic acid F is supplied to the upper region Cf without making the formic acid supply section 19 as the gas supplier. Alternatively, in the case where the inert gas such as the nitrogen gas Ge does not have to be supplied, the nitrogen supply section 18 may not be provided (may be omitted).

In the description that has been made so far, the heating apparatus according to the embodiment of the present disclosure has been described mainly with reference to FIG. 1 and FIG. 2 as the example. However, the configurations, structures, numbers, arrangements, shapes, materials, and the like of each of the sections are not limited to the above specific example. The components that are appropriately and selectively adopted by the person skilled in the art are included in the scope of the present invention as long as the gist of the present invention is included.

All references, including publications, patent applications, and patents, cited herein are hereby incorporated by reference to the same extent as if each reference were individually and specifically indicated to be incorporated by reference and were set forth in its entirety herein.

The use of the terms "a" and "an" and "the" and similar referents in the context of describing the invention (especially in the context of the following claims) is to be construed to cover both the singular and the plural, unless otherwise indicated herein or clearly contradicted by context. The terms "comprising," "having," "including," and "containing" are to be construed as openended terms (i.e., meaning "including, but not limited to,") unless otherwise noted. Recitation of ranges of values herein are merely intended to serve as a shorthand method of referring individually to each separate value falling within the range, unless otherwise indicated herein, and each separate value is incorporated into the specification as if it were individually recited herein. All methods described herein can be performed in any suitable order unless otherwise indicated herein or otherwise clearly contradicted by context. The use of any and all examples, or exemplary language (e.g., "such as") provided herein, is intended merely to better illuminate the invention and does not pose a limitation on the scope of the invention unless otherwise claimed. No language in the specification should be construed as indicating any non-claimed element as essential to the practice of the invention.

Preferred embodiments of this invention are described herein, including the best mode known to the inventors for carrying out the invention. Variations of those preferred embodiments may become apparent to those of ordinary skill in the art upon reading the foregoing description. The inventors expect skilled artisans to employ such variations as appropriate, and the inventors intend for the invention to be practiced otherwise than as specifically described herein. Accordingly, this invention includes all modifications and equivalents of the subject matter recited in the claims appended hereto as permitted by applicable law. Moreover, any combination of the above-described elements in all possible variations thereof is encompassed by the invention unless otherwise indicated herein or otherwise clearly contradicted by context.

### DESCRIPTION OF REFERENCE NUMERALS AND SYMBOLS

- 1: heating apparatus
- 11: chamber
- 11p: outlet port
- 13: stage
- 15: heater
- 18: nitrogen supply section
- 19: formic acid supply section
- 21: thermal insulator
- 23: pressure gauge
- 33: substance catching section
- 35: vacuum pump
- 41: discharge pipe
- 43: bypass pipe
- 45: on-off valve
- 50: controller
- C: internal space
- Ce: lower region
- Cf: upper region
- D: gap
- F: formic acid
- Ge: nitrogen gas
- W: object

## Claims

1. A heating apparatus, comprising:
a chamber configured to accommodate an object, the object producing an evaporated substance upon heating;
a stage on which the object accommodated in the chamber is placed, the stage partitioning an internal space of the chamber into a lower region at a lower portion and an upper region at an upper portion;
a heating section configured to heat the object placed on the stage; and
a gas supplier configured to supply gas to the lower region,
wherein the chamber has an outlet port for discharging fluid from the chamber, the outlet port being formed in the upper region, and
wherein the stage includes a gap through which the gas supplied to the lower region by the gas supplier flows from the lower region to the upper region along a wall surface of the chamber.

2. The heating apparatus according to claim 1, further comprising a chamber wall surface temperature decrease suppression member configured to suppress a temperature decrease of the wall surface of the chamber.

3. The heating apparatus according to claim 1 or claim 2, further comprising a substance catching section configured to catch the substance, which is contained in the fluid that has flowed out from the chamber via the outlet port.

4. The heating apparatus according to claim 3, comprising:
a discharge channel for introducing, to the substance catching section, the fluid that has flowed out via the outlet port;
a vacuum pump configured to suction the fluid from the chamber, the vacuum pump being disposed downstream of the substance catching section;
a bypass channel configured to enable the fluid that has flowed out from the chamber to bypass the substance catching section and be delivered to the vacuum pump;
an on-off valve configured to open and close the bypass channel;
a substance flow rate detection section configured to directly or indirectly detect a flow rate of the substance in the fluid that has flowed out from the chamber; and
a controller configured to close the on-off valve when a value detected by the substance flow rate detection section exceeds a predetermined value, and to open the on-off valve when the value detected by the substance flow rate detection section is equal to or lower than the predetermined value.

5. A method for manufacturing a soldered object by using the heating apparatus according to any one of claims 1 to 4, the method comprising:
providing the object, which has a solder, in the chamber;
supplying the gas to the chamber such that the gas supplied to the lower region flows from the lower region to the upper region along a wall surface of the chamber; and
effecting a solder joint by increasing a temperature of the object.
